# EUROPÄISCHE PATENTANMELDUNG

(11) **EP 2 799 980 A2**
(43) Veröffentlichungstag der Anmeldung: **05.11.2014**
(21) Anmeldenummer: 14163797.5
(22) Anmeldetag: 08.04.2014
(51) Int. Cl.: G06F 7/58

(54) **Vorrichtung und Verfahren zum Erzeugen von Zufallsbits**

(30) Priorität: 03.05.2013 DE 102013208154
(71) Anmelder: Siemens Aktiengesellschaft, 80333 München (DE)
(72) Erfinder: Böffgen, Pascale, 81247 München (DE); Dichtl, Markus, 80636 München (DE)

(57) **Zusammenfassung**

Die Vorrichtung (1) zum Erzeugen von Zufallsbits (ZB) umfasst mehrere Abbildungseinrichtungen (2₁ - 2ₘ), wobei eine jeweilige Abbildungseinrichtung (2₁ - 2ₘ) eingerichtet ist, eine vorgegebene Anzahl n Eingangssignale (E₁₁ - Eₘₙ) mit Hilfe einer kombinatorischen Abbildung (K₁ - Kₘ) in eine vorgegebene Anzahl p Ausgangssignale (A₁₁ - Aₘₚ) abzubilden, und wobei die Abbildungseinrichtungen (2₁ - 2ₘ) miteinander verkettet sind und mindestens eine kombinatorische Abbildung (K₁ - Kₘ) derart eingerichtet ist, dass eine Zustandsänderung eines Eingangssignals (E₁₁ - Eₘₙ) einer jeweiligen Abbildungseinrichtung (2₁ - 2ₘ) im Mittel auf mehr als ein Ausgangssignal (A₁₁ - Aₘₚ) der jeweiligen Abbildungseinrichtung (2₁ - 2ₘ) abgebildet wird, wobei keine Rückkopplungsschleife derart vorliegt, dass eine Zustandsänderung mindestens eines Rückkopplungsausgangssignals (Aᵢⱼ) einer bestimmten Abbildungseinrichtung (2ᵢ) als eine Zustandsänderung mindestens eines Eingangssignals (Eₖₗ) einer anderen Abbildungseinrichtung (2ₖ) derart zugeführt ist, dass eines oder mehrere Ausgangssignale (Aᵢ₁ - Aᵢₚ) der bestimmten Abbildungseinrichtung (2ᵢ) von der Zustandsänderung des Rückkopplungsausgangssignals (Aᵢⱼ) beeinflusst wird.

Dadurch muss die Vorrichtung nicht kontinuierlich Umschaltvorgänge in einer Implementierung als Digitalschaltung vollziehen, was den Stromverbrauch begrenzt.

## Beschreibung

Die vorliegende Erfindung betrifft eine Vorrichtung und ein Verfahren zum Erzeugen eines oder mehrerer Zufallsbits. Es wird zum Beispiel eine Zufallsbitfolge erzeugt, welche als binäre Zufallszahl verwendet wird. Die vorgeschlagenen Vorrichtungen und Verfahren zum Erzeugen von Zufallsbits dienen beispielsweise der Implementierung von Zufallszahlengeneratoren.

In sicherheitsrelevanten Anwendungen, beispielsweise bei asymmetrischen Authentifikationsverfahren, sind Zufallsbitfolgen als binäre Zufallszahlen notwendig. Dabei ist es gewünscht, insbesondere bei mobilen Anwendungen einen möglichst geringen Hardwareaufwand zu betreiben. Bekannte Maßnahmen, um Zufallszahlen zu erzeugen, sind beispielsweise Pseudozufallszahlengeneratoren, analoge Zufallsquellen, Ringoszillatoren und deren Abwandlungen.

Bei Pseudozufallszahlengeneratoren werden Seeds verwendet, von denen ausgehend deterministische Pseudozufallszahlen berechnet werden. Zur Erzeugung des Seeds wird in der Regel ein physikalischer Zufallsgenerator verwendet. Als analoge Zufallsquellen werden Rauschquellen, wie z.B. das Rauschen von Zenerdioden, verstärkt und digitalisiert. Dabei ist die Verbindung von digitaler mit analoger Schaltungstechnik meist nur aufwändig zu verwirklichen.

Bei Ringoszillatoren, die aus einer ungeraden Anzahl von hintereinander geschalteten Invertern aufgebaut sind, ergeben sich zufällige Jitter aus schwankenden Durchlaufzeiten der Signale durch die Inverter. Diese Jitter, also eine unregelmäßige zeitliche Schwankung in Zustandsänderungen der durch die Inverter geschickten Signale, können bei mehrfachen Durchläufen durch die Ringoszillatorschaltung akkumuliert werden, so dass letztlich ein zufälliges analoges Signal entsteht. Nachteilig bei Ringoszillatoren ist häufig die notwendige lange Zeit vom Start der Schwingung bis ein brauchbar zufälliges Signal aufgrund der Jitter-Akkumulierung entsteht. Daher ergeben sich meist niedrige nicht akzeptable Datenerzeugungsraten bei Ringoszillatoren. Ferner ist möglich, dass die sich addierenden Jitter-Beiträge sich auch selbst wieder aufheben, so dass im Mittel zufällige kurze Gatterlaufzeiten durch zufällige längere Gatterlaufzeiten kompensiert werden.

Fibonacci- und Galois-Ringoszillatoren erzeugen schneller zufällige Signalformen als klassische Ringoszillatoren. Allerdings werden verschiedene digitale Gatter wie XOR- und NOT-Gatter eingesetzt. Dadurch können sich insbesondere bei Implementierungen auf ASICs große Geschwindigkeitsunterschiede der Gattertypen ergeben. Häufig besteht der Wunsch, mit Hilfe von FPGAs (Field Programmable Gate Arrays) Zufallsbitfolgen zu erzeugen. Allerdings können auch bei diesen Digitalbausteinen beispielsweise aufgrund von Umgebungstemperaturschwankungen periodische Schwingungen einsetzen, die nur eine geringe Entropie oder Zufälligkeit in den Signalen haben.

Ferner kann sich der Energieverbrauch bei Oszillatorschaltungen in Zufallszahlengeneratoren als nachteilig erweisen, denn im Betrieb muss ständig ein elektrischer Strom fließen.

Bei digitalen Schaltungen hängt der Stromverbrauch im Wesentlichen von der Anzahl der Umschaltvorgänge pro Zeit ab. Bei entsprechenden digitalen Schwingschaltungen muss dies ständig stattfinden, so dass ein eher ungünstiger Energieverbrauch bei auf Ringoszillatoren basierenden Zufallszahlengeneratoren entsteht. Insbesondere bei mobilen Anwendungen ist es wünschenswert, den Energieverbrauch bzw. die Stromaufnahme der hardwaremäßig implementierten Schaltungen gering zu halten. Dennoch soll ein statistisch guter physikalischer Zufall entstehen.

Daher besteht eine Aufgabe der vorliegenden Erfindung darin, eine verbesserte Vorrichtung und/oder ein Verfahren zum Erzeugen von Zufallsbits bereitzustellen.

Demgemäß wird eine Vorrichtung zum Erzeugen von Zufallsbits vorgeschlagen, die umfasst: mehrere miteinander verkettete Abbildungseinrichtungen, wobei eine jeweilige Abbildungseinrichtung eingerichtet ist, eine vorgegebene Anzahl n Eingangssignale mit Hilfe einer kombinatorischen Abbildung in eine vorgegebene Anzahl p Ausgangssignale abzubilden. Mindestens eine kombinatorische Abbildung ist derart eingerichtet, dass eine Zustandsänderung eines Eingangssignals einer jeweiligen Abbildungseinrichtung im Mittel auf mehr als ein Ausgangssignal der jeweiligen Abbildungseinrichtung abgebildet wird. Dabei liegt keine Rückkopplungsschleife derart vor, dass eine Zustandsänderung mindestens eines Rückkopplungsausgangssignals einer bestimmten Abbildungseinrichtung als eine Zustandsänderung mindestens eines Eingangssignals einer anderen Abbildungseinrichtung derart zugeführt ist, dass eines oder mehrere Ausgangssignale der bestimmten Abbildungseinrichtung von der Zustandsänderung des Rückkopplungsausgangssignals beeinflusst wird.

Vorzugsweise sind die Abbildungseinrichtungen derart miteinander verkettet, dass keine Rückkopplung entsteht. Dadurch ergibt sich, dass die Vorrichtung nicht kontinuierlich Umschaltvorgänge in einer Implementierung als Digitalschaltung vollziehen muss, was den Stromverbrauch begrenzt.

Man kann sagen, die Vorrichtung entwickelt keine "Schwingungen" oder Signalwechsel propagieren nicht im Kreis. Beispielsweise sind die Ausgangssignale alle vorwärtsgekoppelt. Vorzugsweise hängt keines der Ausgangssignale kausal von sich selbst ab, indem es rückgekoppelt wird.

In Ausführungsformen sind die Abbildungseinrichtungen derart miteinander verkettet, dass keine Rückkopplungsschleife derart ausgebildet ist, dass eine Zustandsänderung mindestens eines Ausgangssignals einer Abbildungseinrichtung als eine Zustandsänderung mindestens eines Eingangssignals einer anderen Abbildungseinrichtung zugeführt ist. Prinzipiell können Rückkopplungspfade vorgesehen sein, die jedoch vorzugsweise nicht zu Schwingungen führen. Grundsätzlich ist es möglich, dass der Ausgang einer Abbildungseinrichtung bzw. ein Ausgangssignal als Eingangssignal für eine im Signalpfad stromaufwärts vorliegende Abbildungseinrichtung genutzt wird.

Die Anzahl der n Eingangssignale einer jeweiligen Abbildungseinrichtung kann der Anzahl p der Ausgangssignale entsprechen. Es ist aber auch denkbar, dass n ungleich p ist, also dass mit Hilfe einer jeweiligen Abbildungseinrichtung die Zustände der Eingangssignale auf Zustände von Ausgangssignalen abgebildet werden, wobei die Anzahl der Ausgangssignale kleiner oder größer als die Anzahl der Eingangssignale für eine jeweilige Abbildungseinrichtung ist.

Die Abbildungseinrichtungen können logische oder kombinatorische Gatter sein, die insbesondere eine bijektive Abbildung von n Eingangssignalen auf n Ausgangssignale realisieren. Die Eingangssignale schwanken zwischen Pegeln, die logischen Zuständen, wie Bits 1 bzw. High oder 0 bzw. Low zugeordnet werden können. Unter einer bijektiven Abbildung versteht man eine eineindeutige Abbildung zwischen den 2ⁿ möglichen logischen Werten der Eingangssignale und den 2ⁿ logischen Werten der Ausgangssignale.

In Ausführungsformen der Vorrichtung ist mindestens eine kombinatorische Abbildung derart eingerichtet, dass die Eingangssignale unter Beaufschlagung eines Jitters und einer logischen Funktion auf die Ausgangssignale abgebildet werden. Durch die hardwaremäßige Implementierung der kombinatorischen Abbildung durch die Abbildungseinrichtungen können sich Jitter, also Schwankungen, in dem zeitlichen Verlauf von Signalflanken ergeben. Dieser Jitter wird dann durch Vollziehen der logischen Funktion, also der Abbildung der Kombination von n Eingangssignalen oder Bitwerten auf p Ausgangssignale oder Bitwerte, jeweils weitergeführt und akkumuliert sich über die Durchläufe durch die Abbildungseinrichtungen.

Insofern ergibt sich in Ausführungsformen der Vorrichtung eine begrenzte Kette von Abbildungseinrichtungen. Die Abbildungseinrichtungen können auch als Knoten oder Gatter bezeichnet sein. Wenigstens eine der kombinatorischen Abbildungen ist insbesondere derart eingerichtet, dass im Mittel bei einer Zustandsänderung eines Eingangssignals an mehr als einem Ausgangssignal ein Zustandswechsel erfolgt. Das führt dazu, dass ein jeweiliger Jitter des Eingangssignals auf mehrere Ausgangssignale abgebildet wird und daher verstärkt wird. Ein einmal aufgetretener Jitter in einem Signal wird mit Hilfe der Abbildungseinrichtungen bzw. der darin implementierten kombinatorischen Abbildungen auf mehrere Ausgangsspuren kopiert, so dass sich Jitter-Komponenten kaum kompensieren können.

In Ausführungsformen ist mindestens eine ausgewählte Abbildungseinrichtung vorgesehen, deren Ausgangssignale von allen Eingangssignalen der übrigen Abbildungseinrichtungen entkoppelt sind. Beispielsweise kann dies die letzte Abbildungseinrichtung einer Kette von m Abbildungseinrichtungen sein, die linear miteinander verkoppelt sind. Es ergibt sich insbesondere ein endlicher Signalverlauf. Das kann bedeuten, dass ausschließlich in einem vorgegebenen Zeitintervall ein Signal- oder ein Zustandswechsel eines Signals sich durch die verketteten Abbildungseinrichtungen fortsetzt. Denn von einer ersten Eingangsabbildungsvorrichtung aus propagiert entlang der verketteten Abbildungseinrichtungen ein sich sukzessive mit Jittern und Zufallsbeiträgen ausbreitendes Zufallssignal bzw. mehrere gemäß der jeweiligen Bitbreite der Abbildungseinrichtungen. Unter einer Entkopplung kann man verstehen, dass die Ausgangssignale nicht an Eingänge anderer Abbildungseinrichtungen geführt sind.

Es können in einem derartigen Signalpfad von einer ersten bis zu einer letzten Abbildungseinrichtung, die als Ausgangsabbildung bezeichnet werden kann, weitere Schaltungen, wie Logikgatter oder Verzögerungselemente, vorgesehen sein. Vorzugsweise sind zumindest einige der Abbildungen keine kombinatorischen Abbildungen, welche ausschließlich eine Permutation der Eingangssignale auf die Ausgangssignale liefern. Eine Permutation der Eingangssignale liegt insbesondere dann vor, wenn die Ausgangssignale den Eingangssignalen entsprechen oder lediglich durch eine Änderung der Reihenfolge aus den Eingangssignalen entstehen. Bei einer Permutation ergibt sich keine "Vervielfältigung" des Jitters.

In Ausführungsformen der Vorrichtung zum Erzeugen von Zufallsbits sind die Abbildungseinrichtungen derart eingerichtet, dass deren Signaldurchlaufzeiten gleich sind. Durch möglichst gleiche Signallaufzeiten wird das Risiko vermindert, dass sich Jitter-Beiträge gegenseitig kompensieren können. Außerdem wird eine Implementierung in der Art von ASICs oder FPGAs erleichtert. Beispielsweise sind die Abbildungseinrichtungen so eingerichtet, dass alle möglichen Zustandswechsel an den jeweiligen Ausgängen alle innerhalb eines Toleranzintervalls von 100 ps und bevorzugt innerhalb von 50 ps erfolgen.

In Ausführungsformen der Vorrichtung umfasst mindestens eine Abbildungseinrichtung eine Lookup-Table bzw. eine Nachschlagetabelle zur Implementierung der kombinatorischen Abbildung. Es ist auch möglich, dass alle Abbildungseinrichtungen mit einer oder mehreren jeweiligen Lookup-Tables versehen sind. Lookup-Tables können einfach ausgelesen werden und erfordern nur einen geringen Hardwareaufwand. Häufig sind in programmierbaren Logikchips, wie FPGAs, entsprechende Felder oder bereits Tabellen vorgesehen.

In Ausführungsformen der Vorrichtung können die Lookup-Tables mit zufälligen Bitwerten unter Verwendung von Zufallselementen gefüllt werden. Es ist beispielsweise möglich, die Lookup-Tables, die in Abhängigkeit von einem Eingangsbitmuster an Eingängen der Abbildungseinrichtungen ein entsprechendes Ausgangsbitmuster an Ausgängen liefern, so zu erzeugen, dass die durch die Lookup-Table repräsentierte Abbildung zufällig aus allen (2ⁿ)! Bijektionen von n logischen Signalen auf n logische Signale ausgewählt wird. Vorzugsweise sind in den Abbildungseinrichtungen jeweils unterschiedliche kombinatorische Abbildungen implementiert.

In Ausführungsformen der Vorrichtung können feste Pegel an die Eingänge einer der Abbildungseinrichtungen, vorzugsweise die erste Abbildungseinrichtung der Kette, angelegt werden, um aus einem wohldefinierten Zustand zu starten. Mindestens einer dieser festen Pegel wird dann auf einen anderen festen Wert umgeschaltet. Anschließend ergibt sich durch die verkettete Anwendung der kombinatorischen Abbildungen auf die Signale ein n oder p Bit breites Zufallsbitsignal.

Vorzugsweise ist die vorgegebene Anzahl n beziehungsweise p von Eingangs- beziehungsweise Ausgangssignalen mindestens drei. In Ausführungsformen ist die Bitbreite oder die Anzahl n beziehungsweise p von vorgegebenen Eingangs- beziehungsweise Ausgangssignalen an den Abbildungseinrichtungen vier oder mehr.

Vorzugsweise ist die Anzahl der Abbildungseinrichtungen in der Kette mindestens 25. In Ausführungsformen sind jedoch auch zwischen 20 und 1000 verkettete Abbildungseinrichtungen vorgesehen.

In Ausführungsformen der Vorrichtung ist eine Erfassungsvorrichtung zum Erfassen eines oder mehrerer Ausgangssignale an Ausgängen einer Abbildungseinrichtung vorgesehen. Die Erfassungsvorrichtung kann auch Ein- oder Ausgangssignale an unterschiedlichen Abbildungseinrichtungen erfassen. Ein Erfassen erfolgt beispielsweise durch Abtasten, beispielsweise getaktet oder zu vorgegebenen anderen Zeitpunkten und dient der Ableitung eines Bitwertes H oder L, der aufgrund des stark schwankenden zufälligen Signals eine hohe Entropie bzw. Zufälligkeit aufweist.

Es ist z.B. möglich, periodisch einen "Zufallslauf" zu erzeugen, indem an eine erste Eingangsabbildungseinrichtung festgelegte Eingangssignalpegel gelegt werden, diese einen gesteuerten Zustandswechsel vollziehen und nach Durchlauf dieses Signals bzw. der sich ergebenden Signalflanke/n durch alle Abbildungseinrichtungen an einer End- oder Ausgangsabbildungseinrichtung die anliegenden Ausgangssignale oder eines der Ausgangssignale erfasst wird. Innerhalb des jitter- und zufallsbehafteten Signalverlaufs kann gesampelt werden oder ein Zwischenspeicherelement erfasst die zeitlich nicht vorhersagbaren Zustandswechsel. Möglich ist auch, eine Zählereinrichtung an die Ausgänge, beispielsweise der letzten Ausgangsabbildungseinrichtung, anzulegen, welche Signalflanken zählt Der oder die sich ergebenden Bitwerte können als Zufallsbit verstanden werden.

In Ausführungsformen umfasst die Erfassungsvorrichtung mindestens ein Zwischenspeicherelement. Das Zwischenspeicherelement kann ein Flip-Flop, wie zum Beispiel ein T-Flip-Flop, oder eine Latch-Einrichtung aufweisen. Denkbar sind auch einer oder mehrere Zähler zum Erfassen von Signalflanken oder Zustandswechseln einzelner Signale. Ein T-Flip-Flop ist insbesondere geeignet, steigende oder fallende Signalflanken modulo 2 zu zählen.

Die Erfassungseinrichtung ist insbesondere eingerichtet, ein Ausgangssignal in Abhängigkeit von einem anderen Ausgangssignal abzutasten. Denkbar ist zum Beispiel, dass eine Signalflanke eines ersten Ausgangssignals das Abtasten eines anderen Ausgangssignals triggert oder hervorruft.

In Ausführungsformen ist die Erfassungsvorrichtung eingerichtet, eine zeitliche Reihenfolge von Zustandswechseln von Ausgangssignalen zu erfassen. Zum Ableiten eines Zufallsbitwerts wird beispielsweise die Reihenfolge von erfassten Signalzustandswechseln an einer Auswahl von Ausgängen bzw. in Ausgangssignalen bestimmt. Je nach Reihenfolge wird dann ein Zufallsbitwert bestimmt oder definiert.

In Ausführungsformen ist die Vorrichtung Teil einer FPGA-Einrichtung oder einer ASIC-Einrichtung.

Es wird darüber hinaus ein Verfahren zum Erzeugen von Zufallsbits vorgeschlagen, bei dem mehrere kombinatorische Abbildungen verkettet nacheinander durchgeführt werden. Dabei bildet eine jeweilige kombinatorische Abbildung eine vorgegebene Anzahl n Eingangssignale auf eine vorgegebene Anzahl p Ausgangssignale ab. Es wird mindestens eine kombinatorische Abbildung derart gewählt, dass eine Zustandsänderung eines Eingangssignals durch die kombinatorischen Abbildungen im Mittel auf mehr als ein Ausgangssignal abgebildet wird. Dabei wird keine Rückkopplungsschleife derart erzeugt, dass eine Zustandsänderung mindestens eines Rückkopplungsausgangssignals einer bestimmten kombinatorischen Abbildung als eine Zustandsänderung mindestens eines Eingangssignals für eine andere kombinatorische Abbildung derart zugeführt wird, dass eines oder mehrere Ausgangssignale der bestimmten Abbildung von der Zustandsänderung des Rückkopplungsausgangssignals beeinflusst wird.

Ein jeweiliges Eingangssignal kann z.B. einen Bitwert darstellen. Die kombinatorischen Abbildungen können als n auf p Abbildungen bezeichnet werden.

Bei dem Verfahren sind die kombinatorischen Abbildungen vorzugsweise derart miteinander verkettet, dass keine Rückkopplungsschleife entsteht. Insbesondere werden Rückkopplungen vermieden, bei denen eine Zustandsänderung mindestens eines Ausgangssignals einer Abbildungseinrichtung als eine Zustandsänderung mindestens eines Eingangssignals einer anderen Abbildungseinrichtung zugeführt wird, die beispielsweise signalpfadaufwärts in der Kette vorliegt. Vorzugsweise werden kombinatorische Abbildungen nur vorwärts verkettet bzw. die Abbildungseinrichtungen seriell hintereinander geschaltet und ohne Rückkopplung betrieben.

Das Verfahren kann insbesondere über geeignete Beschreibungssprachen, beispielsweise VHDL oder Verilog, auf oder in einer FPGA- oder ASIC-Vorrichtung implementiert werden. Bei der FPGA-Vorrichtung bzw. dem Verfahren sind die Abbildungseinrichtungen vorzugsweise derart eingerichtet, dass Zustandsänderungen an einem Eingangssignal der n Eingangssignale in Abhängigkeit von der kombinatorischen Abbildung zu einem gleichen Zeitpunkt einen Zustandswechsel in einem oder mehreren der p Ausgangssignale möglichst zeitgleich hervorrufen.

Weitere mögliche Implementierungen der Erfindung umfassen auch nicht explizit genannte Kombinationen von zuvor oder im Folgenden bezüglich der Ausführungsbeispiele beschriebenen Vorrichtungen oder Verfahrensvarianten. Dabei wird der Fachmann auch Einzelaspekte als Verbesserungen oder Ergänzungen zu der jeweiligen Grundform der Erfindung hinzufügen oder abändern.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Dabei zeigen:
- Fig. 1: eine schematische Darstellung eines ersten Ausführungsbeispiels für eine Vorrichtung zum Erzeugen von Zufallsbits;
- Fig. 2 - 4: zeitliche Verläufe von Zufallsbitsignalen, welche gemäß Ausführungsbeispielen des Verfahrens und der Vorrichtung zum Erzeugen von Zufallsbits erzeugt sind;
- Fig. 5: einen zeitlichen Verlauf der Stromaufnahme eines Ausführungsbeispiels der Vorrichtung zum Erzeugen von Zufallsbits; und
- Fig. 6: eine schematische Darstellung eines weiteren Ausführungsbeispiels für eine Vorrichtung zum Erzeugen von Zufallsbits.

In den Figuren sind funktionsgleiche Elemente mit denselben Bezugszeichen versehen, sofern nichts anderes angegeben ist.

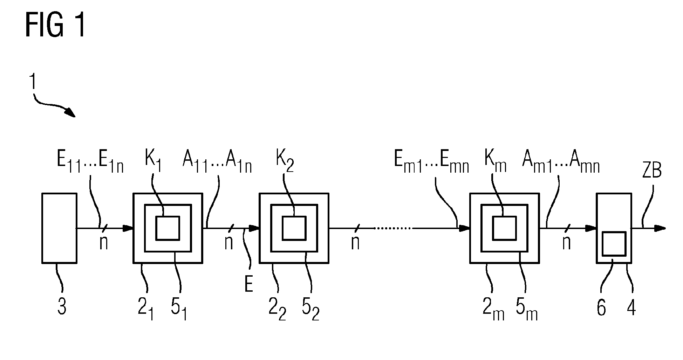

Die Fig. 1 zeigt eine schematische Darstellung eines ersten Ausführungsbeispiels für eine Vorrichtung zum Erzeugen von Zufallsbits. Die Vorrichtung 1 ist in der Art einer Kette von Abbildungseinrichtungen 2₁ - 2ₘ ausgestaltet. Dazu sind seriell hintereinander kombinatorische Digitalschaltungen 2₁ - 2ₘ gekoppelt. Die kombinatorischen Digitalschaltungen 2₁ - 2ₘ können auch als logische Gatter oder Abbildungseinrichtungen für eine jeweilige kombinatorische Abbildung K₁ - Kₘ verstanden werden.

Ferner ist eine Starteinrichtung 3 vorgesehen, die festgelegte Werte für die Eingangssignale E₁₁ - E₁ₙ für die erste Abbildungseinrichtung 2₁ bereitstellt. An die letzte Ausgangsabbildungseinrichtung 2ₘ der Kette ist eine Erfassungs- oder Abtastvorrichtung 4 gekoppelt, die die Ausgangssignale Aₘ₁ - Aₘₙ der letzten Abbildungseinrichtung 2ₘ erfasst. Beispielsweise werden dazu Latches oder Flip-Flops 6 eingesetzt, die Signalflanken innerhalb des zufälligen Signalverlaufs erfassen. Aus den erfassten Pegeln lässt sich ein Zufallsbit oder eine Zufallszahl ZB ableiten, die von der Abtasteinrichtung 4 ausgegeben werden kann. In der Fig. 1 ist n = p.

Jede Abbildungseinrichtung 2ᵢ hat n Eingänge für ein n Bit breites Eingangssignal Eᵢⱼ mit j = 1...n und p Ausgänge für ein p Bit-breites Ausgangssignal Aᵢⱼ mit j = 1...p. In der Fig. 1 sind die Ein- und Ausgänge nicht explizit angegeben. Eine jeweilige Abbildungseinrichtung 2ᵢ empfängt insofern Eᵢ₁ - Ein Eingangssignale und gibt Aᵢ₁ - Aᵢₚ Ausgangssignale aus. Die Verknüpfung zwischen Ein- und Ausgangssignalen ist über eine kombinatorische Abbildung Kᵢ realisiert. Man erkennt in der Darstellung der Fig. 1, in der n = p ist, dass die K₁ bis Kₘ kombinatorischen Abbildungen hintereinander verkettet erfolgen.

Beim Betrieb der Vorrichtung zum Erzeugen von Zufallsbits 1 propagieren mit Jittern beaufschlagte Signale von der ersten Eingangsabbildungseinrichtung 2₁ bis zur Ausgangsabbildungseinrichtung 2ₘ. Die Abbildungseinrichtungen 2₁ - 2ₘ sind derart als kombinatorische Abbildungen K₁ - Kₘ implementiert, dass im Mittel ein Zustandswechsel des an einem jeweiligen Eingang vorliegenden Signals Eₖ₁ - Eₖₙ zu einem Zustandswechsel in mehr als einem der Ausgangssignale Aₖ₁ - Aₖₙ führt. Das heißt, eine Veränderung eines jeweiligen Input-Bits bzw. eines logischen Zustandes eines Eingangssignals Eₖⱼ führt im Mittel zu Änderungen in mehr als einem der Output-Bits des jeweiligen Knotens bzw. der jeweiligen Abbildungseinrichtung. Insofern akkumulieren und vervielfältigen sich Jitter, die in den Signalen E₁₁ bis Eₘₙ bzw. A₁₁ bis A_{m-1,n} vorliegen, beim Durchlauf durch die verketteten Abbildungseinrichtungen 2₁ bis 2ₘ. Das bedeutet, je länger der Signalweg ist, also je mehr verkettete seriell verschaltete Abbildungseinrichtungen 2₁ - 2ₘ vorliegen, desto stärker wird ein vorliegender Jitter verstärkt und auf die n oder p verschiedenen Kanäle kopiert.

Obgleich dies der Einfachheit halber in der Fig. 1 so dargestellt ist, müssen die Abbildungseinrichtungen 2₁ - 2ₘ nicht zwingend dieselbe Anzahl n von Ein- und Ausgängen haben. Die Bitbreite kann in der Fig. 1 im Verlauf des Signalweges von der Startvorrichtung 3 zur Abtastvorrichtung 6 variieren. Beispielsweise werden m=100 Abbildungseinrichtungen nacheinander gekoppelt. Die Abbildungseinrichtungen können die jeweilige kombinatorische Abbildung K₁ bis Kₘ in der Art von Lookup-Tables 5₁ - 5ₘ implementieren.

Die jeweilige Signaldurchlaufzeit in einer Abbildungseinrichtung bzw. einem logischen oder kombinatorischen Gatter 2ᵢ ist für alle Eingangssignale Eᵢ₁ bis Eᵢₙ im Wesentlichen gleich, so dass aufgrund der implementierten kombinatorischen Abbildung Kᵢ der Wechsel eines logischen Zustands an einem Eingangssignal Eᵢⱼ im Wesentlichen zeitgleich zu logischen Wechseln an einem oder mehreren Ausgangssignalen Aᵢₗ mit l = 1...n ist. Insofern ergeben sich n Kanäle mit zufälligen Signalformen, die von den Jittern hervorgerufen sind, die von den die digitalen Abbildungseinrichtungen aufbauenden Schaltelementen hervorgerufen sind.

Die schematisch angedeutete Vorrichtung zum Erzeugen von Zufallsbits 1 lässt sich insbesondere aufwandsgünstig in FPGA- oder ASIC-Einrichtungen realisieren. Gegenüber konventionellen Ringoszillatoren lassen sich mit einer höheren Datenrate Zufallsbits erzeugen, da insbesondere der den Zufall begünstigende Jitter mit Hilfe der mehreren Kanäle potenziell n-fach vervielfältigt wird. Es ist durch die vielen Kanäle und Abbildungen unwahrscheinlich, dass Jitter-Beiträge einander kompensieren. Insofern kann aufwandsgünstig ein Zufallszahlengenerator mit einer hohen Zufallsbit-Erzeugungsfrequenz realisiert werden.

Aufgrund der linearen Topologie und endlichen Anzahl von kombinatorischen Abbildungen bzw. Abbildungseinrichtungen 2₁ - 2ₘ durchläuft eine Signalflanke oder eine Eingangssignaländerung unter Beaufschlagung eines Jitters und Anwendung der kombinatorischen Abbildungen eine begrenzte Anzahl von Logikgattern. Demnach ist auch die Anzahl der Umschaltvorgänge beim Durchlauf einer Signalflanke oder Signaländerung von der Starteinrichtung 3 bis zur Abtasteinrichtung 6 endlich. Es ergibt sich dadurch ein besonders niedriger Stromverbrauch, so dass die vorgeschlagene Vorrichtung insbesondere zum Einsatz in mobilen Anwendungen, beispielsweise auf Chipkarten, geeignet ist.

Vorzugsweise sind mindestens 20 Abbildungseinrichtungen verkettet miteinander vorgesehen. In Ausführungsformen sind jedoch auch 50 oder 100 Abbildungen denkbar. Bevorzugt ist die Anzahl der miteinander verketteten Abbildungen bzw. Abbildungseinrichtungen zwischen 50 und 100. In besonderen Ausführungsformen ist die Anzahl zwischen 100 und 1.000 Abbildungseinrichtungen.

Im Folgenden werden Beispiele für Zufallszahlenerzeuger betrachtet, bei denen die Anzahl der Eingangssignale n=4 ist und die Anzahl der Ausgangssignale ebenfalls n=p=4. Bereits für 25 hintereinander verkettete Abbildungen oder Abbildungseinrichtungen ergeben sich zufällige Bitzustände an den Ausgängen der letzten Abbildungseinrichtung in der Kette.

In der folgenden Tabelle ist eine beispielhafte kombinatorische Abbildung K_{q} dargestellt, die n=4 Eingangszustände bzw. Eingangssignale E_{q1} - E_{q4} auf p=4 Ausgangszustände bzw. Ausgangssignale A_{q1} - A_{q4} abbildet. Zur Vereinfachung der Darstellung wird angenommen, dass die Eingangssignale E_{q1} - E_{q4} und die Ausgangssignale A_{q1} - A_{q4} logische Zustände 0 oder 1 bzw. L oder H repräsentieren, obwohl durch die "Verzufälligung" und starke Beaufschlagung mit zufälligen Jittern eher keine wohldefinierten logischen Pegel in der als Hardware bzw. als Schaltung implementierten Vorrichtung zum Erzeugen von Zufallsbits vorliegen.

| E_{q4} | E_{q3} | E_{q2} | E_{q1} | A_{q4} | A_{q3} | A_{q2} | A_{q1} |
|---|---|---|---|---|---|---|---|
| 0 | 0 | 0 | 0 | 0 | 1 | 0 | 0 |
| 0 | 0 | 0 | 1 | 1 | 0 | 0 | 1 |
| 0 | 0 | 1 | 0 | 0 | 0 | 1 | 1 |
| 0 | 0 | 1 | 1 | 1 | 1 | 1 | 0 |
| 0 | 1 | 0 | 0 | 1 | 1 | 1 | 1 |
| 0 | 1 | 0 | 1 | 0 | 0 | 0 | 1 |
| 0 | 1 | 1 | 0 | 1 | 0 | 0 | 0 |
| 0 | 1 | 1 | 1 | 0 | 1 | 1 | 1 |
| 1 | 0 | 0 | 0 | 1 | 0 | 1 | 1 |
| 1 | 0 | 0 | 1 | 0 | 1 | 1 | 0 |
| 1 | 0 | 1 | 0 | 1 | 1 | 0 | 0 |
| 1 | 0 | 1 | 1 | 0 | 1 | 0 | 1 |
| 1 | 1 | 0 | 0 | 0 | 0 | 1 | 0 |
| 1 | 1 | 0 | 1 | 1 | 1 | 0 | 1 |
| 1 | 1 | 1 | 0 | 0 | 0 | 0 | 0 |
| 1 | 1 | 1 | 1 | 1 | 0 | 1 | 0 |

Die Tabelle kann als Lookup-Tabelle zur Ausbildung der Abbildungseinrichtung 2q implementiert werden. Dabei wird eine bijektive Abbildung realisiert, sodass jedes mögliche Bitmuster aus vier Eingangsbits oder Eingangssignalzuständen E_{q1}, E_{q2}, E_{q3}, E_{q4} genau einmal an den Ausgängen der Abbildungseinrichtung 2q als Ausgangssignalzustände A_{q1}, A_{q2}, A_{q3}, A_{q4} auftritt.

Für den Fall, dass die Eingangssignale E_{q1}, E_{q2}, E_{q3}, E_{q4} initial ein Bitmuster 0000 bilden, was laut Zeile 1 der Tabelle auf Ausgangssignale 0100 abgebildet wird, und das Eingangssignal E_{q1} einen Zustandswechsel vollzieht, ergibt sich als Ausgangsbitmuster gemäß der zweiten Zeile der obigen Tabelle 1001. Das heißt, der Zustandswechsel des Eingangssignals E_{q1} von 0 auf 1 wird mit Hilfe der kombinatorischen Abbildung K_{q} auf die drei Ausgangssignale A_{q1}, A_{q3} und A_{q4} "vervielfältigt". Denn das Ausgangssignal A_{q1} ändert sich aufgrund der Zustandsänderung von E_{q1} von 0 auf 1, das Ausgangssignal A_{q3} von 1 auf 0 und das Ausgangssignal A_{q4} von 0 auf 1.

Ein Eingangsbitmuster von 0010 führt zu einem Ausgangsbitmuster 0011 (vgl. dritte Zeile der Tabelle). Ausgehend von einem Bitmuster 0000 und einem Zustandswechsel des Eingangssignals E_{q2} von 0 auf 1 ergeben sich daher Zustandswechsel bei den drei Ausgangssignalen A_{q1}, A_{q2} und A_{q3}, obgleich nur ein eingangsseitiger Zustandswechsel im Eingangssignal E_{q2} erfolgt ist.

Analog erkennt man für Eingangsbitmuster 0100 und 1000 ausgehend von 0000, dass sich drei oder alle vier Ausgangszustände ändern. Untersuchungen der Anmelderin für alle möglichen Zustandsänderungen von einzelnen Eingangssignalen ausgehend von allen 16 Eingangsbitmustern haben ergeben, dass bei der dargestellten Abbildung K_{q} im Mittel ein Zustandswechsel oder eine Zustandsänderung eines Eingangssignals E_{qi} zu 2,75 Zustandswechseln oder Zustandsänderungen in Ausgangssignalen führt.

Insofern werden bei der Umsetzung der kombinatorischen Abbildungen als elektronische Schaltkreise die Signalflanken, die den Zustandswechseln entsprechen, mit weiteren Jittern beaufschlagt und auf mehrere, im vorliegenden Beispiel auf 2,75, Ausgangssignale "kopiert". Insbesondere wird ein jitterbehaftetes Eingangssignal in mehrere jitterbehaftete Ausgangssignale überführt bzw. abgebildet, wobei durch die jeweilige Abbildung selbst zusätzliche Jitter ergänzt werden. Der Jitter, der als zufallsgebendes Phänomen genutzt wird, wird somit verstärkt und auf mehrere Kanäle verteilt.

Die als Beispiel in Tabellenform wiedergegebene kombinatorische Abbildung K_{q} kann äquivalent in Form von Booleschen Funktionen dargestellt werden.

Als disjunktive Normalform geschrieben lautet die kombinatorische Abbildung K_{q}:
A_{q4} =
   OR [AND(E_{q4}, E_{q3}, E_{q1}),
   AND (E_{q4}, NOT[E_{q3}], NOT[E_{q1}]),
   AND (NOT[E_{q4}], E_{q3}, NOT[E_{q1}]),
   AND (NOT[E_{q4}], NOT[E_{q3}], E_{q1})],
A_{q3} =
   OR [AND(E_{q4}, NOT[E_{q3}], E_{q2}),
   AND (Eq₄, NOT [E_{q2}], E_{q1}),
   AND (NOT [E_{q4}], E_{q2}, E_{q1}),
   AND (NOT [E_{q4}], NOT [E_{q2}], NOT [E_{q1}])]
A_{q2} =
   OR [AND(E_{q4}, NOT[E_{q3}], NOT[E_{q2}]),
   AND (NOT [E_{q4}], NOT [E_{q3}], E_{q2}),
   AND (E_{q3}, E_{q2}, E_{q1}),
   AND (E_{q3}, NOT [E_{q2}], NOT[E_{q1}])]
A_{q1} =
   OR [AND (E_{q4}, NOT (E_{q3}), E_{q2}, E_{q1}),
   AND (E_{q4}, NOT [E_{q3}], NOT[E_{q2}], NOT[E_{q1}]),
   AND (NOT [Eq₄], E_{q3}, NOT [E_{q2}]),
   AND (NOT [E_{q4}], E_{q3}, E_{q1}),
   AND (NOT [E_{q4}], NOT [E_{q3}], E_{q2}, NOT [E_{q1}]),
   AND (NOT [E_{q4}], NOT [E_{q2}], E_{q1}),
   AND (E_{q3}, NOT [E_{q2}], E_{q1})]

Dabei steht OR für eine logische ODER-Verknüpfung, AND für eine logische UND-Verknüpfung und NOT für eine logische NICHT-Verknüpfung. Zur hardwaremäßigen Implementierung können die kombinatorischen Abbildungen anstelle einer Lookup-Tabelle auch als Verknüpfung von logischen Gattern gemäß der obigen Darstellung realisiert werden. Die disjunktive Normalformdarstellung kann auch in eine algebraische Normalform umgeschrieben werden, welche ebenfalls zum Entwurf von entsprechenden logischen Schaltungen verwendet werden kann. Man kann schreiben:
A_{q4} =XOR [E_{q1}, E_{q3}, E_{q4}]
A_{q3}=NOT[XOR(E_{q1}, E_{q2}, E_{q4}, AND [E_{q4}, E_{q2}, E_{q1}] AND [E_{q4}, E_{q3}, E_{q2}])]
A_{q2}=XOR[E_{q2}, E_{q3}, E_{q4}, AND (E_{q3}, E_{q1}) AND (E_{q4}, E_{q3})]
A_{q1}=XOR[E_{q1}, E_{q2}, E_{q3}, E_{q4}, AND (E_{q3}, E_{q1}), AND (E_{q3}, E_{q2}, E_{q1}),
   AND (Eq₄, E_{q3}, E_{q1}), AND (E_{q4}, E_{q3}, E_{q2})]

Man erkennt in beiden Darstellungen, dass das Ausgangssignal A_{q4} unabhängig von einem Zustandswechsel des Eingangssignals E_{q2} ist. Eine noch weiter optimierte Konstruktion der kombinatorischen Abbildungen K_{q} sieht vor, dass ein jeweiliges Ausgangssignal von möglichst vielen Eingangssignalen abhängt. Besonders bevorzugt wäre, dass jedes Ausgangssignal einer kombinatorischen Abbildung von allen Eingangssignalen für die Abbildung abhängig ist. Dann würden sich Jitter in den Signalen besonders gut multiplizieren und verstärken.

Untersuchungen der Anmelderin haben ergeben, dass günstige zufällige Signalpegel an den Ausgängen der letzten Abbildungseinrichtung in der Kette vorliegen, auch wenn gleiche Anfangszustände von der Startvorrichtung 3 vorgegeben werden und ein jeweiliger Zustandswechsel der Anfangszustände der Eingangssignale E₁₁ - E₁ₙ zum Starten der Vorrichtung initiiert wird. Die zufälligen Signalverläufe Aₘ₁ - Aₘₙ, welche mit Hilfe der Abtast- oder Erfassungseinrichtung 4 erfasst werden, können zum Beispiel während ihres "Durchlaufs" an der Erfassungseinrichtung 4 abgetastet werden.

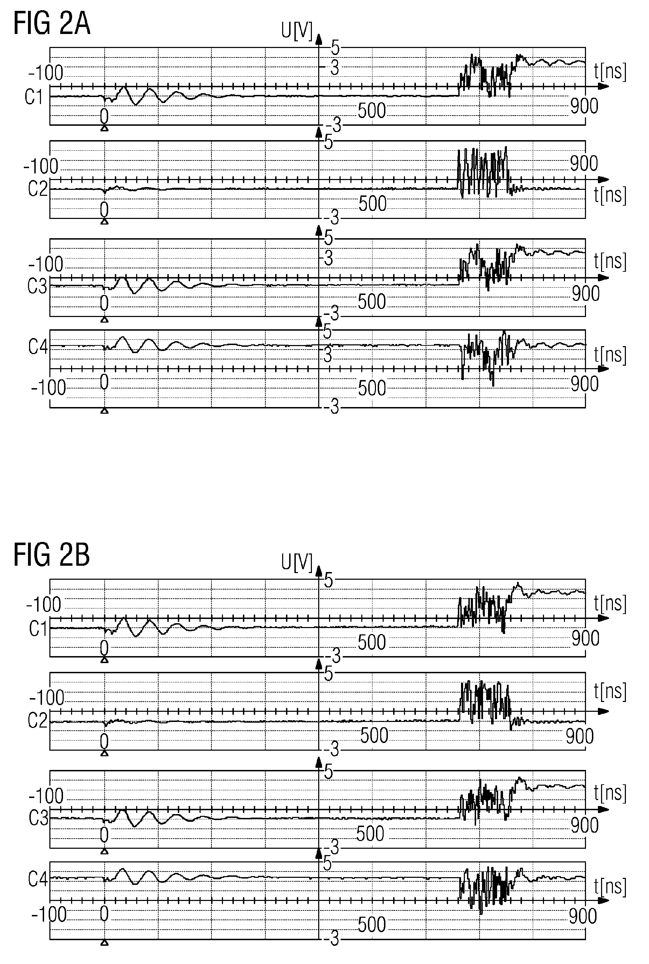

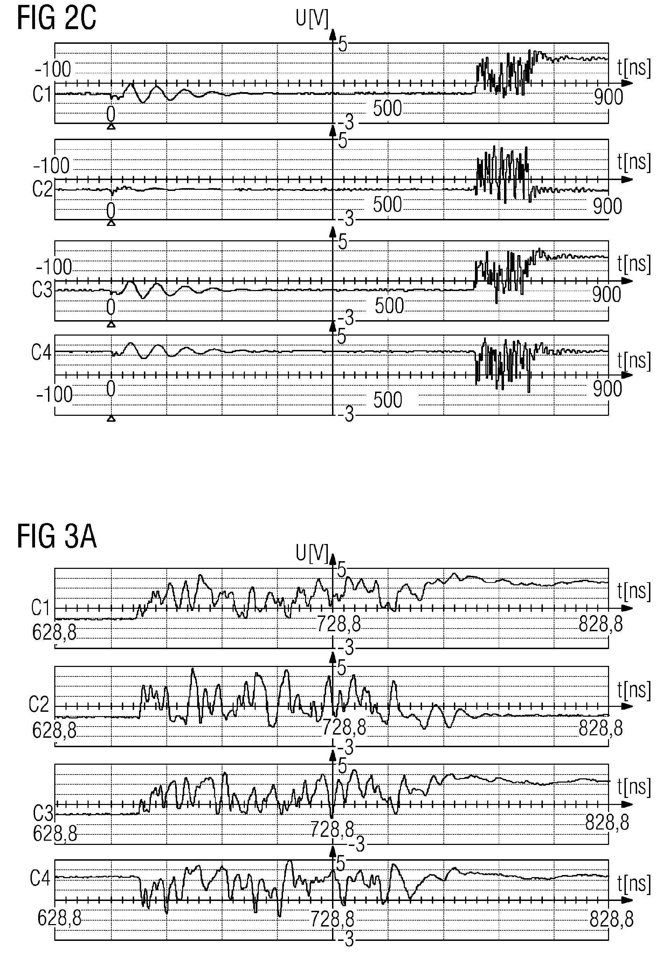

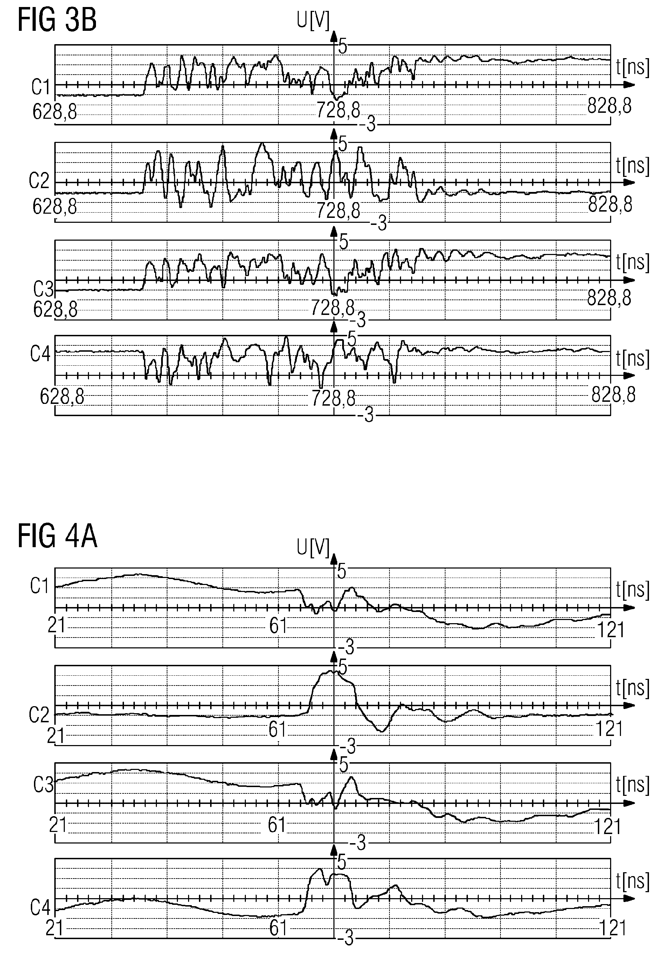

Die Fig. 2 und 3 zeigen Verläufe von Zufallsbitsignalen, die mit einer FPGA-Implementierung der in Fig. 1 schematisch angedeuteten Schaltung erzeugt sind. Dabei werden m=1000 logische Gatter oder Abbildungseinrichtungen miteinander verkettet. Die kombinatorischen Abbildungen sind als vier auf vier Abbildungen festgesetzt worden. D.h. vier Eingangssignale werden auf vier Ausgangssignale abgebildet.

Auf der Y-Achse ist der jeweilige Signalpegel der Ausgangssignale A_{1000,1} - A_{1000,4} dargestellt. Auf der X-Achse ist die Zeit in Nanosekunden aufgetragen. Dabei zeigt die Fig. 2A, die Fig. 2B und die Fig. 2C jeweils die Signalverläufe für verschiedene Runs oder Starts, bei denen mit Hilfe einer Starteinrichtung 3 die Signalpegel der Eingangssignale E₁₁ - E₁₄ von 0 auf 1 geändert wurden. Nach Durchlauf der 1000 logischen Gatter bzw. Abbildungseinrichtungen 2₁ - 2₁₀₀₀ wird eine praktisch zufällige Signalform an den Ausgängen der letzten Abbildungseinrichtung abgegriffen. Dabei steht die Kurve c1 für das Ausgangssignal A_{1000,1}, die Kurve c2 für das Ausgangssignal A_{1000,2}, die Kurve c3 für das Ausgangssignal A_{1000,3} und die Kurve c4 für das Ausgangssignal A_{1000,4}.

Für das Durchlaufen oder Propagieren werden etwa 650 bis 670 ns benötigt. Eine geringe Schwankung kann sich durch verschiedene Durchlaufzeiten durch die Abbildungen bzw. Gatter ergeben. Man erkennt, dass die Signale A_{1000,1} in den Fig. 2A, 2B und 2C eine völlig unterschiedliche Form haben. Dasselbe gilt für die Ausgangssignale A_{1000,2}, A_{1000,3} und A_{1000,4}. Beispielsweise kann das jeweilige Signal einem T-Flip-Flop zugeführt werden, das die Signalflanken modulo 2 erfasst. Der sich ergebende Ausgangsbitwert eines entsprechenden T-Flip-Flops kann als Zufallsbit ZB betrachtet werden.

Die Fig. 3A und 3B zeigen erneut die Ausgangssignalformen c1, c2, c3 und c4 für zwei Durchgänge bzw. Runs eines 1000 Gatter langen Zufallsbitgenerators. Die Fig. 3A und 3B entsprechen Ausschnittdarstellungen der Signalverläufe zwischen etwa 630 und 830 ns. Es ist deutlich zu erkennen, dass die Signalformen aus der Fig. 3A von den Signalformen der Fig. 3B verschieden sind. Es ergeben sich damit unterschiedliche Zufallsbitsignale.

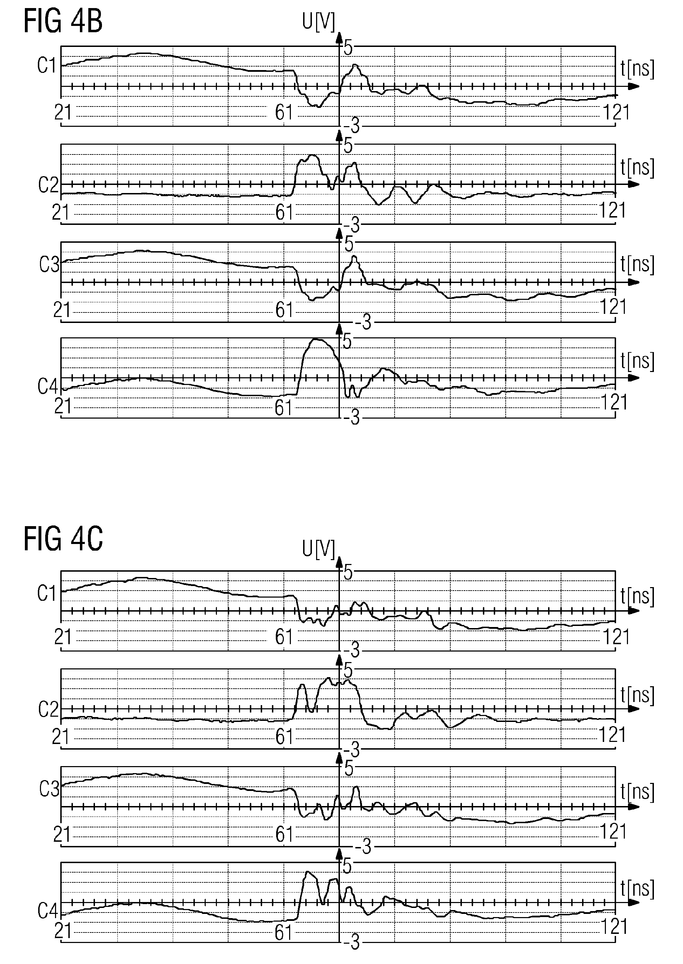

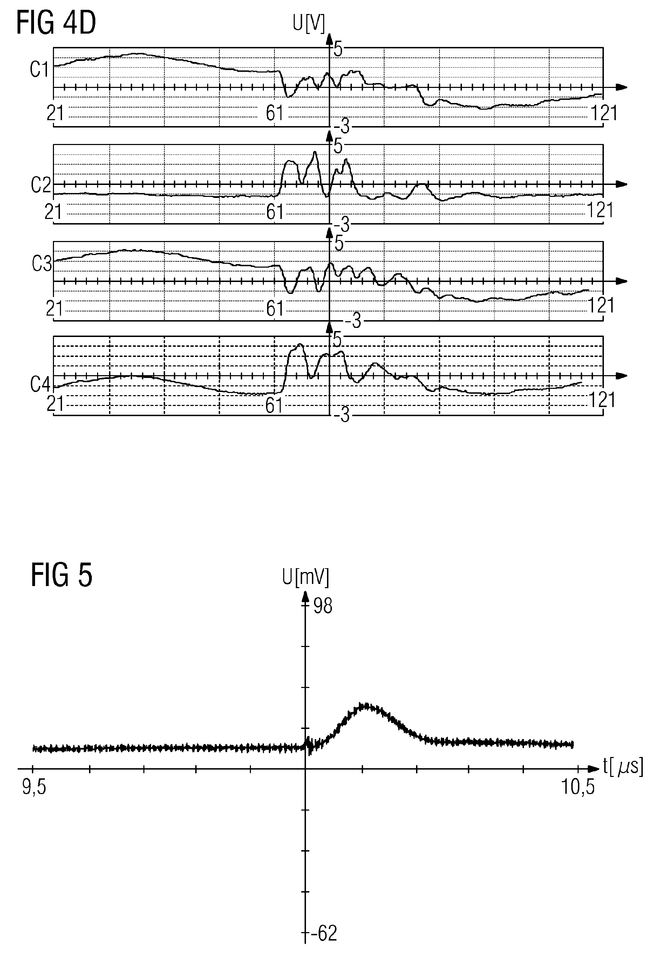

Die Fig. 4A, 4B, 4C, 4D zeigen entsprechende Signalformen für einen 100 Gatter langen Zufallszahlengenerator in einer FPGA-Implementierung. Insofern sind die Signalverläufe der Ausgangsignale A_{100,1} (Kurve c1), A_{100,2} (Kurve c2), A_{100,3} (Kurve c3) und A_{100,4} (Kurve c4) in Abhängigkeit von der Zeit dargestellt. Es ist ein Ausschnitt von 100 ns dargestellt. Der Signalwechsel erfolgt im Vergleich zu dem in den Fig. 3A, 3B, 3C wegen der geringeren Gesamtsignallaufzeit früher.

Die Fig. 4A, 4B, 4C, 4D belegen, dass etwa nach 62 ns die Signalformen am Ende bzw. an der Ausgangsabbildungseinrichtung 2₁₀₀ vorliegen. Bei 100 Knoten können die verwendeten kombinatorischen Abbildungen K₁ bis K₁₀₀ beispielsweise mit Hilfe von 400 Lookup-Tables realisiert werden.

In der Fig. 5 ist der Stromverbrauch eines Zufallsbitgenerators mit 100 kombinatorischen Abbildungen mit vier Spuren illustriert. Es wurde wiederum auf der Basis eines FPGA-Chips die Kette von 100 Abbildungseinrichtungen realisiert, wobei die kombinatorischen Abbildungen mit Hilfe von Lookup-Tables realisiert wurden. Die Fig. 5 zeigt die Messung der Spannung, die über einen 1 Ohm großen Widerstand der Stromversorgung des FPGA-Boards abfällt, als Funktion der Zeit.

Es wurden 25 Schaltungen gleichzeitig implementiert, so dass die über den Widerstand R=1Ω abfallende Spannung für 25 Zufallsbitgeneratoren gilt. Es wurden über 70.000 Zufallsbiterzeugungen durchgeführt und über den Spannungsabfall gemittelt. Die Fig. 5 zeigt den Spannungsabfall in Millivolt über einen 1-Ohm-Widerstand in Abhängigkeit von der Zeit, die in µs angegeben ist.

Wie man in der Fig. 4 erkennen kann, ist nach 75 ns ein Signal durch die 100 logischen Gatter bzw. Abbildungen propagiert. Der mittlere Stromverbrauch wurde aber, um weitere Effekte einzuschließen, durch Integration über 300 ns bestimmt. Bezieht man den Energieverbrauch auf etwa 75 ns, die für die tatsächliche Erzeugung von Zufallsbits notwendig wären, ergäbe sich eine Stromaufnahme von etwa 1,2 mA. Bei einer Betriebsspannung des FPGA-Boards von 1,2 V erhält man 10⁻¹⁰ Ws Energieverbrauch pro Zufallsbit bzw. Zufallsbitmustererzeugung bei einer Bitbreite von n=4. Im Vergleich zu konventionellen Ringoszillatoren ist dies ein geringerer Strom, denn bei Ringoszillatoren muss eine Einschwingzeit einkalkuliert werden, während der der Ringoszillator viele Schwingungen vollzieht und aufgrund der vielen Signalwechsel viel Energie benötigt. Insofern ergeben sich ein höchst energieeffizientes Verfahren und eine Vorrichtung zum Erzeugen von Zufallsbits.

Zudem können die Zufallsbits mit hoher Rate erzeugt werden, denn eine Einschwingzeit ist nicht notwendig. Vielmehr ist eine obere Grenze der Zufallsbiterzeugungsrate die Durchlaufzeit durch die verketteten Abbildungen bzw. Abbildungseinrichtungen oder logischen Gatter. Bei dem vorbeschriebenen Beispiel mit 100 hintereinander verketteten logischen oder kombinatorischen Abbildlungen kann nach 75-80 ns eine erneute Zufallsbiterzeugung stattfinden.

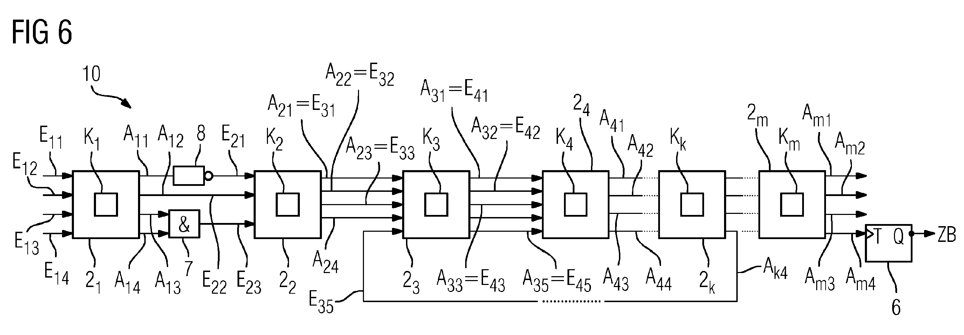

Die Fig. 6 zeigt eine schematische Darstellung eines weiteren Ausführungsbeispiels für eine Vorrichtung zum Erzeugen von Zufallsbits. Die Vorrichtung 10 implementiert einige optionale Abwandlungen bezüglich der in Fig. 1 dargestellten Vorrichtung 1. Die Fig. 6 zeigt m hintereinander geschaltete Abbildungsvorrichtungen 2₁ bis 2ₘ, die jeweils kombinatorische Abbildungen K₁ - Kₘ implementieren. Dabei ist die Bitbreite der Abbildungen nicht konstant. Beispielsweise sind die Abbildungsvorrichtungen 2₁ und 2ₖ - 2ₘ als kombinatorische Abbildungen implementiert, die vier Eingangssignale auf vier Ausgangssignale abbilden.

Die kombinatorische Abbildung K₂, die in der Abbildungseinrichtung 2₂ implementiert ist, bildet drei Eingangssignale E₂₁, E₂₂, E₂₃ auf vier Ausgangssignale A₂₁, A₂₂, A₂₃, A₂₄ ab. Die in der dritten Abbildungseinrichtung 2₃ implementierte kombinatorische Abbildung K₃ bildet fünf Eingangssignale auf fünf Ausgangssignale ab. Die vierte kombinatorische Abbildung K₄ die mit Hilfe der Abbildungsvorrichtung 2₄ implementiert ist, bildet fünf Eingangs- auf vier Ausgangssignale ab.

Das Ausgangssignal A₁₁ wird mit Hilfe eines Inverters 8 in ein Eingangssignal E₂₁ für die zweite Abbildungseinrichtung 2₂ invertiert. Die beiden Ausgangssignale A₁₃ und A₁₄ der ersten Abbildungseinrichtung 2₁ werden mit Hilfe eines logischen Gatters 7 miteinander verundet und als Eingangssignal E₂₃ der zweiten Abbildungseinrichtung 2₂ zugeführt.

Grundsätzlich ist es von Vorteil, wenn ausschließlich vorwärts gekoppelte Signalpfade entstehen. Es ist jedoch unschädlich, wenn beispielsweise Rückkopplungspfade auftreten, bei denen eine Zustandsänderung eines Ausgangssignals, beispielsweise des Ausgangssignals Aₖ₄, als Eingangssignal E₃₅ rückgekoppelt ist, aber die kombinatorische Abbildung K₃ auf einen Zustandswechsel des Eingangssignals E₃₅ nicht reagiert oder keine Vervielfältigung auf andere Ausgangssignale A₃₁ bis A₃₅ entsteht. Bei den Zufallsbiterzeugungsvorrichtungen ist keine Rückkopplungsschleife derart gebildet, dass eine Zustandsänderung mindestens eines Ausgangssignals einer Abbildungseinrichtung als eine Zustandsänderung mindestens eines Eingangssignals einer anderen Abbildungseinrichtung insbesondere signalpfadaufwärts zugeführt wird. Es würde genügen, solche Rückkopplungen auszuschließen, bei denen eine Zustandsänderung eines rückgekoppelten Ausgangssignals einer bestimmten Abbildungseinrichtung 2ₖ als eine Zustandsänderung mindestens eines Eingangssignals E₃₅ einer anderen Abbildungseinrichtung 2₃ derart zugeführt ist, dass eines oder mehrere Ausgangssignale Aₖ₁ - Aₖ₄ der bestimmten Abbildungseinrichtung 2ₖ von der Zustandsänderung des rückgekoppelten Ausgangssignals Aₖ₄ beeinflusst wird. Sozusagen hängt keines der Ausgangssignale von sich selbst ab.

Das Ausgangssignal Aₘ₄ wird einem Toggle-Flip-Flop 6 zugeführt. Das Toggle-Flip-Flop 6 zählt die steigenden Signalflanken als 0 auf 1-Durchgänge modulo 2. Am Datenausgang Q des Flip-Flops 6 ist dann ein jeweiliges Zufallsbit abgreifbar.

Die vorgeschlagene Vorrichtung und das zugrunde liegende Verfahren eignen sich insbesondere zur Implementierung in ASICs. Die logischen Funktionen der Abbildungseinrichtungen haben vorzugsweise dieselbe logische Tiefe, um eine gleiche Signallaufzeit der kombinatorischen Abbildungen zu erzielen. Auf Lookup-Tables kann insofern auch verzichtet werden. Die Erfindung ermöglicht also unter anderem eine schnelle Zufallsbiterzeugung bei geringem Hardwareaufwand.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Vorrichtung (1) zum Erzeugen von Zufallsbits (ZB) umfassend:
mehrere Abbildungseinrichtungen (2₁ - 2ₘ), wobei eine jeweilige Abbildungseinrichtung (2₁ - 2ₘ) eingerichtet ist, eine vorgegebene Anzahl n Eingangssignale (E₁₁ - Eₘₙ) mit Hilfe einer kombinatorischen Abbildung (K₁ - Kₘ) in eine vorgegebene Anzahl p Ausgangssignale (A₁₁ - Aₘₚ) abzubilden,
wobei die Abbildungseinrichtungen (2₁ - 2ₘ) miteinander verkettet sind und mindestens eine kombinatorische Abbildung (K₁ - Kₘ) derart eingerichtet ist, dass eine Zustandsänderung eines Eingangssignals (E₁₁ - Eₘₙ) einer jeweiligen Abbildungseinrichtung (2₁ - 2ₘ) im Mittel auf mehr als ein Ausgangssignal (A₁₁ - Aₘₚ) der jeweiligen Abbildungseinrichtung (2₁ - 2ₘ) abgebildet wird,
wobei keine Rückkopplungsschleife derart vorliegt, dass eine Zustandsänderung mindestens eines Rückkopplungsausgangssignals (Aᵢⱼ) einer bestimmten Abbildungseinrichtung (2ᵢ) als eine Zustandsänderung mindestens eines Eingangssignals (Eₖₗ) einer anderen Abbildungseinrichtung (2ₖ) derart zugeführt ist, dass eines oder mehrere Ausgangssignale (Aᵢ₁ - Aᵢₚ) der bestimmten Abbildungseinrichtung (2ᵢ) von der Zustandsänderung des Rückkopplungsausgangssignals (Aᵢⱼ) beeinflusst wird.

2. Vorrichtung (1) nach Anspruch 1, mit mindestens einer ausgewählten Abbildungseinrichtung (2ₘ), deren Ausgangssignale (Aₘₙ) von allen Eingangssignalen (Eᵢⱼ) der übrigen Abbildungseinrichtungen (2₁ - 2ₘ₋₁) entkoppelt sind.

3. Vorrichtung (1) nach Anspruch 1 oder 2, wobei mindestens eine kombinatorische Abbildung (K₁ - Kₘ) derart eingerichtet ist, dass die Eingangssignale (E₁₁ - Eₘₙ) unter Beaufschlagung eines Jitters und einer logischen Funktion auf die Ausgangssignale (A₁₁ - Aₘₚ) abgebildet werden.

4. Vorrichtung (1) nach einem der Ansprüche 1 - 3, wobei die kombinatorischen Abbildungen (K₁ - Kₘ) keine kombinatorische Abbildung implementieren, welche eine Permutation der Eingangssignale (E₁₁ - Eₘₙ) auf die Ausgangssignale (A₁₁ - Aₘₚ) liefert.

5. Vorrichtung (1) nach einem der Ansprüche 1 - 4, wobei die Abbildungseinrichtungen (2₁ - 2ₘ) derart eingerichtet sind, dass deren Signaldurchlaufzeiten gleich sind.

6. Vorrichtung (1) nach einem der Ansprüche 1 - 5, wobei mindestens eine Abbildungseinrichtung (2₁ - 2ₘ) eine Lookup-Table (5₁ - 5ₘ) zur Implementierung der kombinatorischen Abbildung (K₁ - Kₘ) umfasst.

7. Vorrichtung (1) nach einem der Ansprüche 1 - 6, wobei mindestens eine kombinatorische Abbildung (Kₘ) eine Bijektion ist.

8. Vorrichtung (1) nach einem der Ansprüche 1 - 7, wobei die Abbildungseinrichtungen (2₁ - 2ₘ) jeweils unterschiedliche kombinatorische Abbildungen (K₁ - Kₘ) implementieren.

9. Vorrichtung (1) nach einem der Ansprüche 1 - 8, wobei mindestens eine Abbildungseinrichtung (2q) als logisches Gatter ausgebildet ist, welches eine vorgegebene Anzahl von Eingangssignalen (E_{q1} - E_{qn}) logisch zu einer vorgegebenen Anzahl von Ausgangssignalen (A_{q1} - A_{qp}) verknüpft.

10. Vorrichtung (1) nach einem der Ansprüche 1 - 9, ferner mit einer Erfassungsvorrichtung (4) zum Erfassen eines oder mehrerer Ausgangssignale (A₁₁ - Aₘₚ) an Ausgängen einer oder unterschiedlicher Abbildungseinrichtungen (2₁ - 2ₘ), wobei die Erfassungseinrichtung (4) insbesondere eingerichtet ist, ein Ausgangssignal (Aᵢⱼ) in Abhängigkeit von einem anderen Ausgangssignal (Aₗₘ) abzutasten.

11. Vorrichtung (1) nach Anspruch 10, wobei die Erfassungsvorrichtung (4) ein Zwischenspeicherelement, insbesondere ein T-Flip-Flop, aufweist.

12. Vorrichtung (1) nach Anspruch 10 oder 11, wobei die Erfassungsvorrichtung (4) eingerichtet ist, eine zeitliche Reihenfolge von Zustandswechseln von Ausgangssignalen (A₁₁ - Aₘₚ) zu erfassen.

13. Vorrichtung (1) nach einem der Ansprüche 1 - 12, wobei die Vorrichtung (1, 100, 101) Teil einer FPGA-Einrichtung oder einer ASIC-Einrichtung ist.

14. Verfahren zum Erzeugen von Zufallsbits (ZB), bei dem mehrere kombinatorische Abbildungen (K₁ - Kₘ) verkettet nacheinander durchgeführt werden, wobei eine jeweilige kombinatorische Abbildung (K₁ - Kₘ) eine vorgegebene Anzahl n Eingangssignale (E₁₁ - Eₘₙ) auf eine vorgegebene Anzahl p Ausgangssignale (A₁₁ - Aₘₚ) abbildet und mindestens eine kombinatorische Abbildung (K₁ - Kₘ) derart gewählt ist, dass eine Zustandsänderung eines Eingangssignals (E₁₁ - Eₘₙ) durch die kombinatorische Abbildung (K₁ - Kₘ) im Mittel auf mehr als ein Ausgangssignal (A₁₁ - Aₘₚ) abgebildet wird, wobei keine Rückkopplungsschleife derart erzeugt wird, dass eine Zustandsänderung mindestens eines Rückkopplungsausgangssignals (Aᵢⱼ) einer bestimmten kombinatorischen Abbildung (Kᵢ) als eine Zustandsänderung mindestens eines Eingangssignals (Eₖₗ für eine andere kombinatorische Abbildung (Kₖ) derart zugeführt wird, dass eines oder mehrere Ausgangssignale (Aᵢ₁ - Aᵢₚ) der bestimmten Abbildung (Kᵢ) von der Zustandsänderung des Rückkopplungsausgangssignals (Aᵢⱼ) beeinflusst wird.

15. Verfahren nach Anspruch 14, wobei die kombinatorischen Abbildungen (K₁ - Kₘ) derart miteinander verkettet sind, dass keine Rückkopplungsschleife ausgebildet wird, bei der eine Zustandsänderung mindestens eines Ausgangssignals (Aᵢⱼ) einer Abbildungseinrichtung (2ᵢ) als eine Zustandsänderung mindestens eines Eingangssignals (Eₖₗ) einer anderen Abbildungseinrichtung (2ₖ), welche signalpfadaufwärts vorgesehen ist, zugeführt ist.
